# EUROPEAN PATENT APPLICATION

(11) **EP 2 879 294 A1**
(43) Date of publication of application: **03.06.2015**
(21) Application number: 14275092.6
(22) Date of filing: 24.04.2014
(51) Int. Cl.: H03L 7/093, H03C 3/09, H03L 7/18

(54) **Frequency synthesizing apparatus and method**

(30) Priority: 27.11.2013 KR 20130145450
(71) Applicant: Samsung Electro-Mechanics Co., Ltd., Gyeonggi-do (KR)
(72) Inventor: Lim, Joon Hyung, Gyeonggi-Do (KR); Kim, Jung Tae, Gyeonggi-Do (KR); Lee, Jae Hyung, Gyeonggi-Do (KR); Kim, Myeung Su, Gyeonggi-Do (KR)
(74) Representative: Potter Clarkson LLP

(57) **Abstract**

A frequency synthesizing apparatus may include: a voltage controlled oscillating unit changing a frequency of an input signal; a dividing unit dividing an oscillation signal output from the voltage controlled oscillating unit according to a dividing ratio; and a modulation unit performing modulation using a divided signal output from the dividing unit as a synchronization signal.

## Description

### CROSS-REFERENCE TO RELATED APPLICATION

This application claims the benefit of Korean Patent Application No. 10-2013-0145450 filed on November 27, 2013, with the Korean Intellectual Property Office, the disclosure of which is incorporated herein by reference.

### BACKGROUND

The present disclosure relates to a frequency synthesizing apparatus and method.

One of the main requirements in the field of wireless communications is miniaturization. Therefore, various types of frequency synthesizing apparatuses have been used in order to satisfy demand for miniaturization.

In the case in which a frequency synthesizing apparatus is operated at a high data rate, distortion of a signal may occur. Therefore, various modulation technologies have been used in order to compensate for the signal distortion.

However, modulation technologies according to the related art have a limitation that an amount of change in modulation and a frequency do not coincide with each other, such that modulation performance may be deteriorated.

Particularly, in the case in which a specific error is present in an oscillation frequency, modulation is performed based on an oscillation frequency that does not contain an error, such that an oscillation error is diffused to a modulation error.

The following Patent Document 1 relates to a phase locked loop (PLL) synthesizer, and the following Patent Document 2 relates to a phase locked loop and wireless electrical signal receiving apparatus. However, the inventions of Patent Documents 1 and 2 still have the above-mentioned problems.

### [Related Art Document]

(Patent Document 1) Japanese Patent Laid-Open Publication No. 2005-198164
(Patent Document 2) Korean Patent Laid-Open Publication No. 2001-0089227

### SUMMARY

An aspect of the present disclosure may provide a frequency synthesizing apparatus and method capable of improving modulation performance by using a divided signal from an oscillation signal as a synchronization signal of modulation to perform modulation in a state in which synchronization with the oscillation signal is secured even in the case in which an error occurs in a frequency.

According to an aspect of the present disclosure, a frequency synthesizing apparatus may include: a voltage controlled oscillating unit changing a frequency of an input signal; a dividing unit dividing an oscillation signal output from the voltage controlled oscillating unit according to a dividing ratio; and a modulation unit performing modulation using a divided signal output from the dividing unit as a synchronization signal.

The modulation unit may provide modulation data to an input of the voltage controlled oscillating unit.

The divided signal may have the same error ratio as that of the oscillation signal.

The frequency synthesizing apparatus may further include a phase frequency detecting unit detecting and outputting a phase difference between the divided signal and a reference signal, wherein the voltage controlled oscillating unit, the dividing unit, and the phase frequency detecting unit configure a loop circuit.

The modulation unit may include: a first modulator performing modulation in connection with the loop circuit; and a second modulator performing modulation in connection with the dividing unit.

According to another aspect of the present disclosure, a frequency synthesizing apparatus may include: a voltage controlled oscillating unit changing a frequency of an input signal; a dividing unit dividing an oscillation signal output from the voltage controlled oscillating unit according to a dividing ratio; a phase frequency detecting unit detecting and outputting a phase difference between the divided signal and a reference signal; and a modulation unit performing modulation in connection with at least one of the voltage controlled oscillating unit and the dividing unit.

The divided signal may have the same error ratio as that of the oscillation signal.

The voltage controlled oscillating unit may configure, together with the dividing unit and the phase frequency detecting unit, a loop circuit, and the modulation unit may include a first modulator performing modulation in connection with the loop circuit.

The voltage controlled oscillating unit may further include a second modulator performing modulation in connection with the dividing unit.

According to another aspect of the present disclosure, a frequency synthesizing method may include: generating an oscillation signal by changing a frequency of an input signal; generating a divided signal by dividing the oscillation signal in a predetermined ratio; adjusting the oscillation signal by detecting a phase difference between the divided signal and a reference signal; and performing modulation using the divided signal as a synchronization signal.

The divided signal may have the same error ratio as that of the oscillation signal.

The performing of modulation may include performing modulation on the oscillation signal.

The performing of modulation may further include performing modulation on the divided signal.

### BRIEF DESCRIPTION OF DRAWINGS

The above and other aspects, features and other advantages of the present disclosure will be more clearly understood from the following detailed description taken in conjunction with the accompanying drawings, in which:
FIG. 1 is a configuration diagram showing an example of a general frequency synthesizing apparatus;
FIG. 2 is a configuration diagram showing a frequency synthesizing apparatus according to an exemplary embodiment of the present disclosure;
FIG. 3 is a configuration diagram showing a frequency synthesizing apparatus according to another exemplary embodiment of the present disclosure;
FIG. 4 is a reference diagram illustrating input and output signals of a phase frequency detecting unit of FIG. 1;
FIG. 5 is a reference diagram showing modulation characteristics of the general frequency synthesizing apparatus;
FIG. 6 is a reference diagram showing modulation characteristics of the frequency synthesizing apparatus according to the present disclosure;
FIG. 7 is a reference diagram illustrating an output signal of a phase frequency detecting unit according to the present disclosure; and
FIG. 8 is a flow chart illustrating a frequency synthesizing method according to an exemplary embodiment of the present disclosure.

### DETAILED DESCRIPTION

Hereinafter, embodiments of the present disclosure will be described in detail with reference to the accompanying drawings. The disclosure may, however, be embodied in many different forms and should not be construed as being limited to the embodiments set forth herein. Rather, these embodiments are provided so that this disclosure will be thorough and complete, and will fully convey the scope of the disclosure to those skilled in the art. Throughout the drawings, the same or like reference numerals will be used to designate the same or like elements.

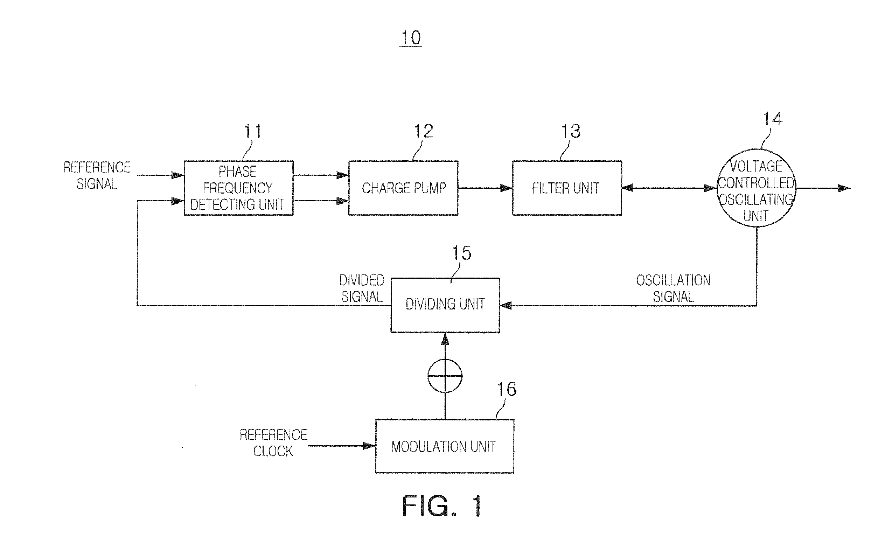

FIG. 1 is a configuration diagram showing an example of a general frequency synthesizing apparatus 10.

An illustrative frequency synthesizing apparatus illustrated in FIG. 1 may include a phase frequency detecting unit 11, a charge pump 12, a filter unit 13, a voltage controlled oscillating unit 14, a dividing unit 15, and a modulation unit 16.

The phase frequency detecting unit 11 may receive a reference signal and a divided signal and compare frequency phases of the reference signal and the divided signal with each other. The phase frequency detecting unit 11 may provide an output signal corresponding to a phase difference between the reference signal and the divided signal to the charge pump 12.

The charge pump 12 may receive an output signal of the phase frequency detecting unit 11 and output a current corresponding to the output signal.

The current output from the charge pump 12 may be input to the filter unit 13, and the filter unit 13 may convert the input current into a voltage and provide the voltage to the voltage controlled oscillating unit 14. Here, the voltage output from the filter unit 13 may be used as a control signal of the voltage controlled oscillating unit 14.

The voltage controlled oscillating unit 14 may include a voltage controlled oscillator. The voltage controlled oscillator may receive the control signal corresponding to the phase difference between the reference signal and the divided signal and output a new oscillation signal depending on the control signal.

The output signal, that is, the new oscillation signal, of the voltage controlled oscillating unit 14 may be divided by the dividing unit 15 and be then fed back to the phase frequency detecting unit 11.

The modulation unit 16 may provide a modulation signal to the divider 15 to perform modulation. The modulation unit 16 may perform synchronization using a reference clock to perform the modulation.

The illustrative frequency synthesizing apparatus 10 illustrated in FIG. 1 has a problem that it may not correct a predetermined error occurring in the modulation.

Particularly, in the case in which the oscillation signal is not changed into a desired frequency at a desired point in time, a phase error occurs, such that quality of a TX modulation signal may be deteriorated.

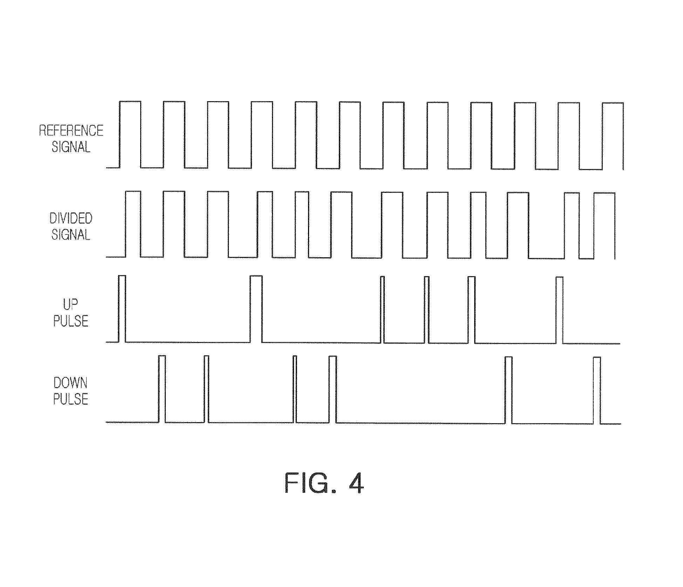

FIG. 4 is a reference diagram illustrating input and output signals of a phase frequency detecting unit of FIG. 1.

That is, FIG. 4 shows an output (up pulse/down pulse) and an input (reference signal/divided signal) of a phase frequency detecting unit (PFD) depending on a modulation signal input.

When the voltage controlled oscillating unit 14 accurately oscillates a frequency depending on given modulation information, an up pulse or a down pulse may not be generated in the phase frequency detecting unit 11.

However, in an example illustrated in FIG. 4, a desired frequency is not oscillated during a modulation section, such that the up pulse or the down pulse is generated in the phase frequency detecting unit 11 during the modulation section. The output of the phase frequency detecting unit 11 again changes a frequency of the voltage controlled oscillating unit 14.

In this case, when the modulation signal is larger than a loop bandwidth of a phase locked loop (PLL), the frequency oscillation may not be smoothly made. Therefore, a frequency variation amount is considered as a phase variation amount to deteriorate quality of the signal.

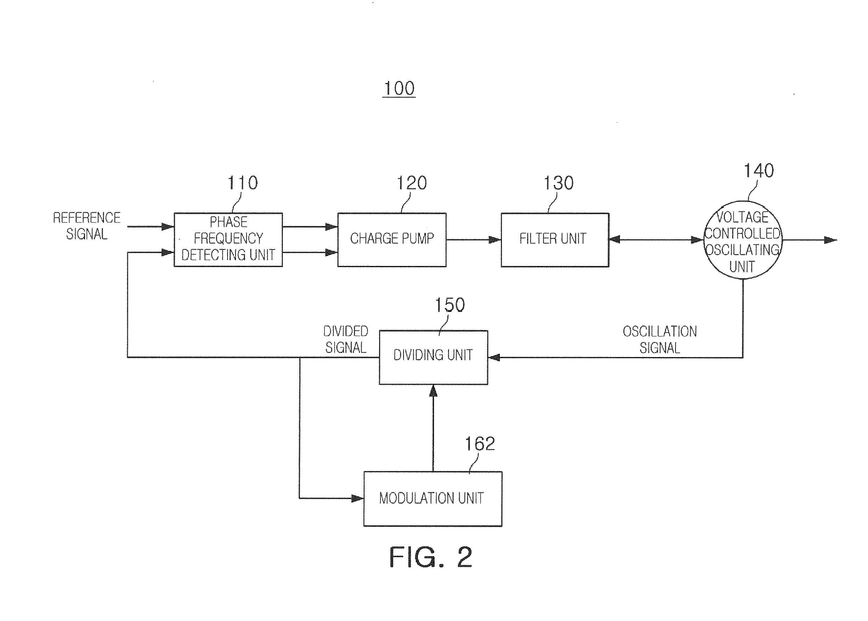

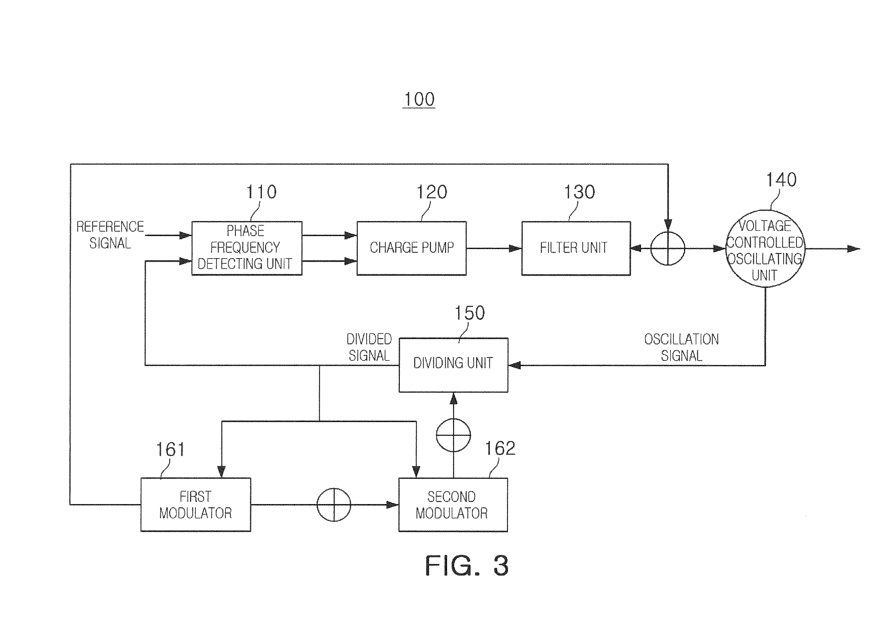

Next, frequency synthesizing apparatuses according to exemplary embodiments of the present disclosure will be described with reference to FIGS. 2 and 3. However, a description of the same content as the content described with reference to FIG. 1 will be omitted.

FIG. 2 is a configuration diagram showing a frequency synthesizing apparatus according to an exemplary embodiment of the present disclosure.

Referring to FIG. 2, a frequency synthesizing apparatus 100 according to an exemplary embodiment of the present disclosure may include a phase frequency detecting unit 110, a charge pump 120, a filter unit 130, a voltage controlled oscillating unit 140, a dividing unit 150, and a modulation unit 160.

The phase frequency detecting unit 110 may detect and output a phase difference between a divided signal and a reference signal, and this phase difference may be provided to an input of the voltage controlled oscillating unit 140 through the charge pump 120 and the filter unit 130.

The voltage controlled oscillating unit 140 may change a frequency of an input signal, and the dividing unit 150 may divide an oscillation signal output from the voltage controlled oscillating unit 140 in a predetermined ratio.

Here, the voltage controlled oscillating unit 140, the dividing unit 150, and the phase frequency detecting unit 110 may configure a loop circuit.

The modulation unit 160 may perform modulation using the divided signal output from the dividing unit 150 as a synchronization signal.

That is, the modulation unit 160 may use the divided signal rather than a reference clock as the synchronization signal for performing the modulation.

In an exemplary embodiment of the present disclosure, the modulation unit 160 may perform modulation in connection with at least one of the voltage controlled oscillating unit 140 and the dividing unit 150.

In an exemplary embodiment of the present disclosure, the divided signal may have the same error ratio as that of the oscillation signal. Therefore, modulation is performed based on the same error ratio as that of the oscillation signal, such that modulation and division are synchronized with each other, whereby quality of modulation may be improved.

FIG. 3 is a configuration diagram showing a frequency synthesizing apparatus according to another exemplary embodiment of the present disclosure.

FIG. 3 shows a detailed example of the modulation unit 160 of the frequency synthesizing apparatus of FIG. 2.

The modulation unit 160 may include a first modulator 161 and a second modulator 162.

The first modulator 161 may perform modulation in connection with the loop circuit.

The second modulator 162 may perform modulation in connection with the dividing unit 150.

In an exemplary embodiment of the present disclosure, the first modulator 161 may be a modulator outputting modulation data, and the second modulator 162 may be a sigma delta modulator using modulation data.

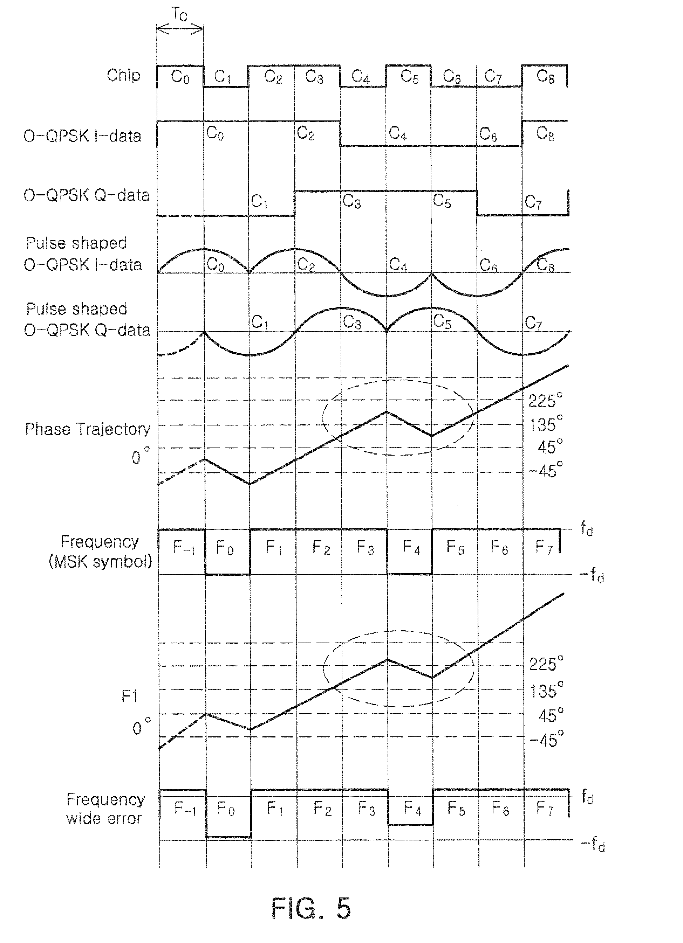

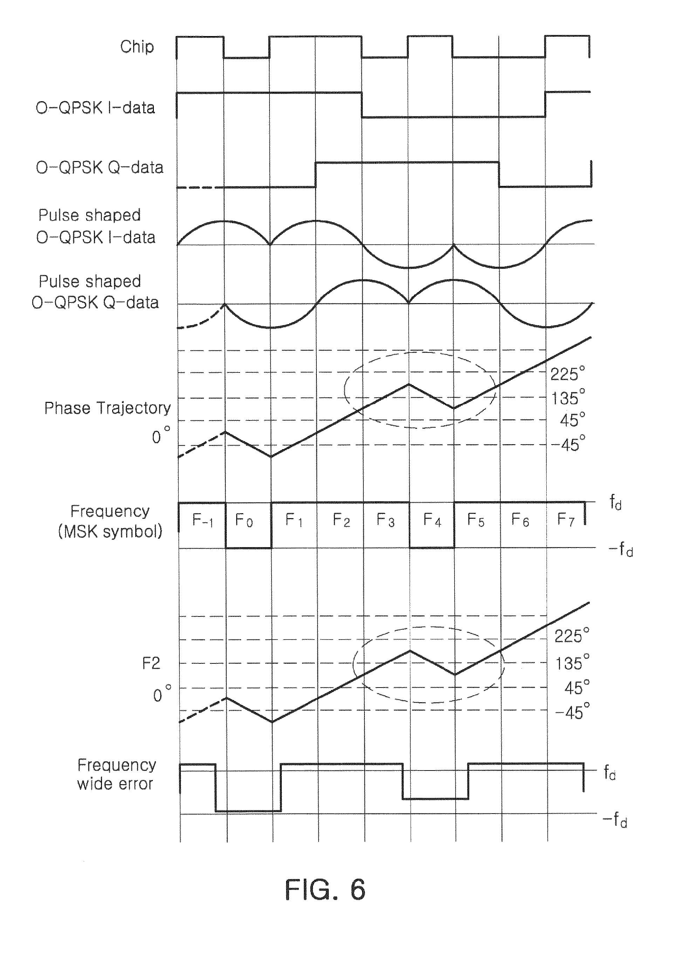

FIG. 5 is a reference diagram showing modulation characteristics of the general frequency synthesizing apparatus; and FIG. 6 is a reference diagram showing modulation characteristics of the frequency synthesizing apparatus according to the present disclosure.

FIGS. 5 and 6 show a conversion process into a frequency shift keying (FSK) signal.

When a frequency offset occurs in a phase of a frequency due to a frequency deviation, phase information may be distorted.

Therefore, it may be determined whether or not the phase information has been distorted by comparing phase changes depending on a frequency error component, that is, integral values of the frequency with each other.

First, in FIG. 5, it may be appreciated that since an integral value F1 is accumulatively affected by an error of a phase, an error of about 90 degrees or more occurs. That is, the phase is significantly distorted to generate a serious phase error in I/Q signals, such that desired I/Q modulation is not implemented.

Meanwhile, in FIG. 6, it may be appreciated that since modulation is performed using the divided signal, the error of the frequency may also be reflected in the modulation, such that synchronization of modulation may be more accurately made.

That is, it may be appreciated that an error of a phase does not substantially occur in an integral value F2. Therefore, it may be appreciated that performance of I/Q modulation may be significantly improved as compared with the example illustrated in FIG. 5.

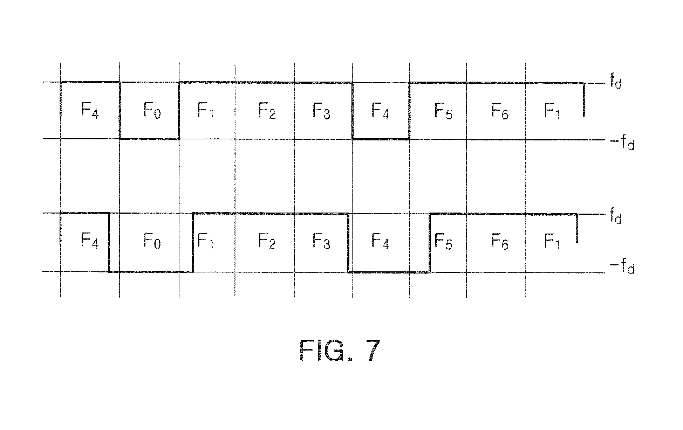

FIG. 7 is a reference diagram for comparing FSK signals with each other.

An upper graph of FIG. 7 shows an FSK signal generated using a reference signal, and a lower graph of FIG. 7 shows an FSK signal generated using a divided signal.

As illustrated in FIG. 7, although a predetermined error is reflected in the FSK signal generated using the divided signal, the FSK signal generated using the divided signal has the same error ratio as that of the error of the divided signal, such that the divided signal and modulation may be synchronized with each other in the modulation.

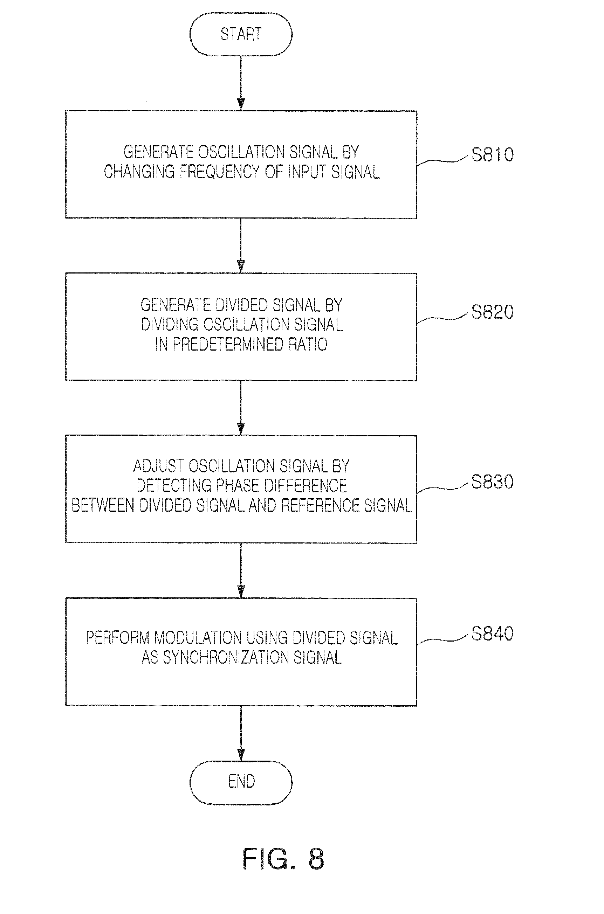

FIG. 8 is a flow chart illustrating a frequency synthesizing method according to an exemplary embodiment of the present disclosure.

Since the frequency synthesizing method according to an exemplary embodiment of the present disclosure illustrated in FIG. 8 is performed by the frequency synthesizing apparatus described with reference to FIGS. 2 and 3, a description of the content described above with reference to FIGS. 2 and 3 and a content corresponding to the content described above with reference to FIGS. 2 and 3 will be omitted.

The frequency synthesizing apparatus 100 may generate the oscillation signal by changing a frequency of the input signal (S810).

The frequency synthesizing apparatus 100 may generate the divided signal by dividing the oscillation signal in a predetermined ratio (S820), and adjust the oscillation signal by detecting a phase difference between the divided signal and the reference signal (S830).

The frequency synthesizing apparatus 100 may perform modulation using the divided signal as the synchronization signal (S840).

Here, the divided signal may have the same error ratio as that of the oscillation signal.

In an example of S840, the frequency synthesizing apparatus 100 may perform modulation on the oscillation signal.

In an example of S840, the frequency synthesizing apparatus 100 may perform modulation on the divided signal.

As set forth above, according to exemplary embodiments of the present disclosure, the divided signal from the oscillation signal is used as the synchronization of modulation to perform modulation in a state in which synchronization with the oscillation signal is secured even in the case in which an error occurs in a frequency, whereby modulation performance may be improved.

While exemplary embodiments have been shown and described above, it will be apparent to those skilled in the art that modifications and variations could be made without departing from the spirit and scope of the present disclosure as defined by the appended claims.

## Claims

1. A frequency synthesizing apparatus comprising:
a voltage controlled oscillating unit changing a frequency of an input signal;
a dividing unit dividing an oscillation signal output from the voltage controlled oscillating unit according to a dividing ratio; and
a modulation unit performing modulation using a divided signal output from the dividing unit as a synchronization signal.

2. The frequency synthesizing apparatus of claim 1, wherein the modulation unit provides modulation data to an input of the voltage controlled oscillating unit.

3. The frequency synthesizing apparatus of claim 1, wherein the divided signal has the same error ratio as that of the oscillation signal.

4. The frequency synthesizing apparatus of claim 1, further comprising a phase frequency detecting unit detecting and outputting a phase difference between the divided signal and a reference signal, wherein the voltage controlled oscillating unit, the dividing unit, and the phase frequency detecting unit configure a loop circuit.

5. The frequency synthesizing apparatus of claim 4, wherein the modulation unit includes:
a first modulator performing modulation in connection with the loop circuit; and
a second modulator performing modulation in connection with the dividing unit.

6. A frequency synthesizing apparatus comprising:
a voltage controlled oscillating unit changing a frequency of an input signal;
a dividing unit dividing an oscillation signal output from the voltage controlled oscillating unit according to a dividing ratio;
a phase frequency detecting unit detecting and outputting a phase difference between the divided signal and a reference signal; and
a modulation unit performing modulation in connection with at least one of the voltage controlled oscillating unit and the dividing unit.

7. The frequency synthesizing apparatus of claim 6, wherein the divided signal has the same error ratio as that of the oscillation signal.

8. The frequency synthesizing apparatus of claim 6, wherein the voltage controlled oscillating unit configures, together with the dividing unit and the phase frequency detecting unit, a loop circuit, and
the modulation unit includes a first modulator performing modulation in connection with the loop circuit.

9. The frequency synthesizing apparatus of claim 8, wherein the voltage controlled oscillating unit further includes a second modulator performing modulation in connection with the dividing unit.

10. A frequency synthesizing method comprising:
generating an oscillation signal by changing a frequency of an input signal;
generating a divided signal by dividing the oscillation signal in a predetermined ratio;
adjusting the oscillation signal by detecting a phase difference between the divided signal and a reference signal; and
performing modulation using the divided signal as a synchronization signal.

11. The frequency synthesizing method of claim 10, wherein the divided signal has the same error ratio as that of the oscillation signal.

12. The frequency synthesizing method of claim 10, wherein the performing of modulation includes performing modulation on the oscillation signal.

13. The frequency synthesizing method of claim 12, wherein the performing of modulation further includes performing modulation on the divided signal.
